Europäisches Patentamt

European Patent Office

Office européen des brevets

(19)

(11) Publication number: **0 098 737**
A2

(12) **EUROPEAN PATENT APPLICATION**

(21) Application number: **83303772.4**

(22) Date of filing: **29.06.83**

(51) Int. Cl.³: **H 01 L 27/08, H 01 L 23/52**

(30) Priority: **30.06.82 JP 113135/82**

(43) Date of publication of application: **18.01.84 Bulletin 84/3**

(84) Designated Contracting States: **DE FR GB**

(71) Applicant: **FUJITSU LIMITED, 1015, Kamikodanaka Nakahara-ku, Kawasaki-shi Kanagawa 211 (JP)**

(72) Inventor: **Inaba, Touru, 539-50, Kamikashio Totsuka-ku, Yokohama-shi Kanagawa 244 (JP)**

(74) Representative: **Fane, Christopher Robin King et al, HASELTINE LAKE & CO. Hazlitt House 28 Southampton Buildings Chancery Lane, London, WC2A 1AT (GB)**

(54) Semiconductor device.

(57) In a semiconductor device comprising: a first transistor having a first gate, said first gate being made of a polycrystalline silicon of a first conductivity type; a second transistor having a second gate, said second gate being made of a polycrystalline silicon of a second conductivity type which is opposite to said first conductivity type, said first and second gates are ohmically connected with a silicide layer to each other.

## SEMICONDUCTOR DEVICE

The present invention relates to a semiconductor device, more particularly to a semiconductor device using p type polycrystalline silicon and n type polycrystalline silicon as a gate material of a metal oxide semiconductor (MOS) type transistor.

As is well known, MOS type integrated circuits (IC's) may be classified into complementary MOS (CMOS) types, comprising both n channel MOS transistors and p channel MOS transistors on one semiconductor substrate, and NMOS or PMOS IC's, which comprises n channel MOS transistors or p channel MOS transistors. Of these MOS type IC's, the CMOS IC is widely used due to its suitability to high integration and its low power consumption.

In order to improve the integration density of the above CMOS IC, it is necessary to shorten the gate length and decrease the number of contact holes through which the gates are connected with each other by wiring. Thus, wiring process technology by which high withstand voltage against the punch through effect, low threshold voltage, and simultaneously, decreased number of contact holes are realized is required.

Some conventional CMOS IC's use n type polycrystalline silicon as a gate regardless of the type of transistor, i.e., n channel or p channel. While a structure wherein only n type polycrystalline silicon is used as a polycrystalline silicon gate has less contact holes and easy wiring designability, the concentration of impurities on a substrate surface of a p channel MOS transistor cannot be satisfactorily increased. Thus, in miniaturization of the p channel MOS transistor, it is difficult to prevent reduction of the punch through withstand voltage and increase of the threshold voltage.

Other conventional CMOS IC's use n type and p type polycrystalline silicon as gates in n channel and p channel MOS transistors, respectively. Here, however, wiring for connecting the n type polycrystalline silicon gate to the p type polycrystalline silicon gate must be carried out by using, for example, aluminum. Thus, there is problem of complicated wiring design and numerous contact holes, thereby preventing miniaturization of the device.

In a p or n channel MOS transistor wherein both p type and n type polycrystalline silicon is used as gate electrodes, the wiring for connecting the polycrystalline silicon gate electrodes must also be carried out by using, for example, aluminum wiring.

It is an object of the present invention to provide a semiconductor device wherein, in a CMOS IC, a p channel MOS transistor can be miniaturized and, at the same time, high withstand voltage of the transistor, low threshold voltage, and decreased number of contact holes can be obtained.

It is another object of the present invention to provide a semiconductor device wherein, in the same type channel MOS transistor having different type conductive gates, a decreased number of contact holes can be obtained.

According to the present invention, there is provided a semiconductor device comprising: a first transistor having a first gate, said first gate being made of a polycrystalline silicon of a first conductivity type; a second transistor having a second gate, said second gate being made of a polycrystalline silicon of a second conductivity type which is opposite to said first conductivity type; and a silicide layer ohmically connecting said first and second gates to each other.

It is advisable that the first transistor and the second transistor form a CMOS transistor.

It is preferably that the first transistor is a p channel MOS transistor and the second transistor is an n channel MOS transistor.

Further, it is preferable that the first conductivity type is the p type and said second conductivity type is the n type.

The silicide is preferably selected from the group consisting of platinum silicide, molybdenum silicide, and tungsten silicide.

Further advantages and details of the present invention will now be explained with reference to the accompanying drawings in which,

Fig. 1 is a cross-sectional view of a main portion of a conventional CMOS IC;

Figs. 2A to 2D are schematic cross-sectional views explaining steps of producing a conventional CMOS IC;

Fig. 3 is a cross-sectional view of a main portion of a CMOS illustrating a contact structure with n type polycrystalline silicon;

Fig. 4 is a main cross-sectional view of a conventional PMOS IC;

Fig. 5A is a main plan view for explaining a CMOS IC according to the present invention;

Fig. 5B is a cross-sectional view of the CMOS IC of Fig. 5A; and

Figs. 6 and 7 are cross-sectional views for explaining other examples according to the present invention.

For better understanding of the invention, a description will first be given of the prior art.

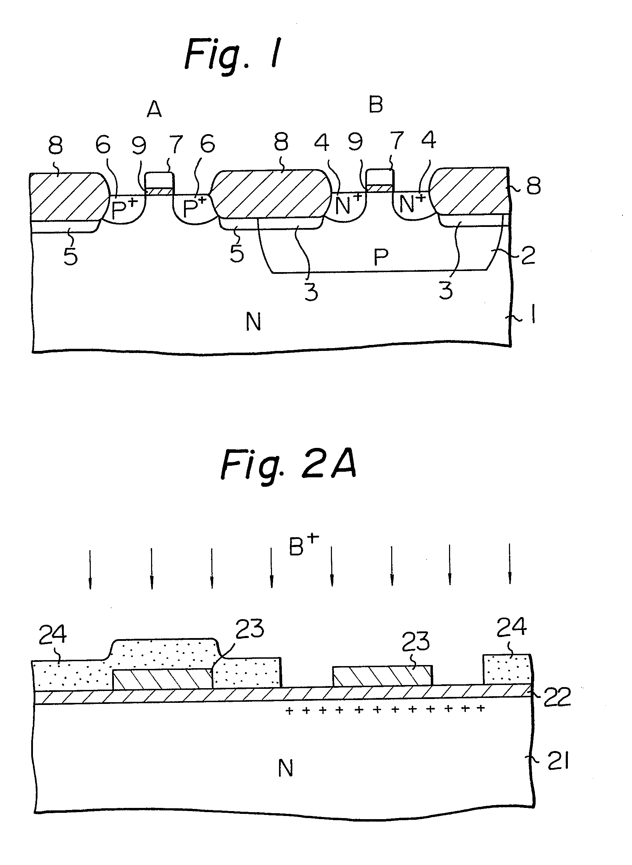

Figure 1 is a cross-sectional view of a main portion of a conventional CMOS IC, wherein a p channel MOS transistor A and n channel MOS transistor B are formed on an n type semiconductor substrate 1. In Fig. 1, reference numerals 2, 3, 4, 5, 6, 7, 8, and 9 respectively show a p type diffusion layer (p well), p type channel cut diffusion layer, $n^+$ source or drain diffusion layer, n type channel cut diffusion layer, p type source or drain diffusion layer, n type polycrystalline silicon gate, field oxidation film, and gate oxidation film.

Figures 2A to 2D are cross-sectional views explaining steps of producing a conventional CMOS IC. Referring to the drawings,

(1)  for example, a silicon dioxide film 22 is formed on the entire surface of an n type silicon substrate 21 (Fig. 2A);

(2)  a silicon nitride ($Si_3N_4$) film 23 is formed on the silicon dioxide layer 22 by, for example, a chemical vapor deposition (CVD) process;

(3)  the silicon nitride film 23 is patterned to open a window for forming a field oxidation portion therein;

(4)  a resist film 24 is formed on the silicon dioxide film 22 and silicon nitride film 23 and the resist film is patterned;

(5)  boron ions are implanted by an ion implantation process;

(6)  the resist film 24 is removed;

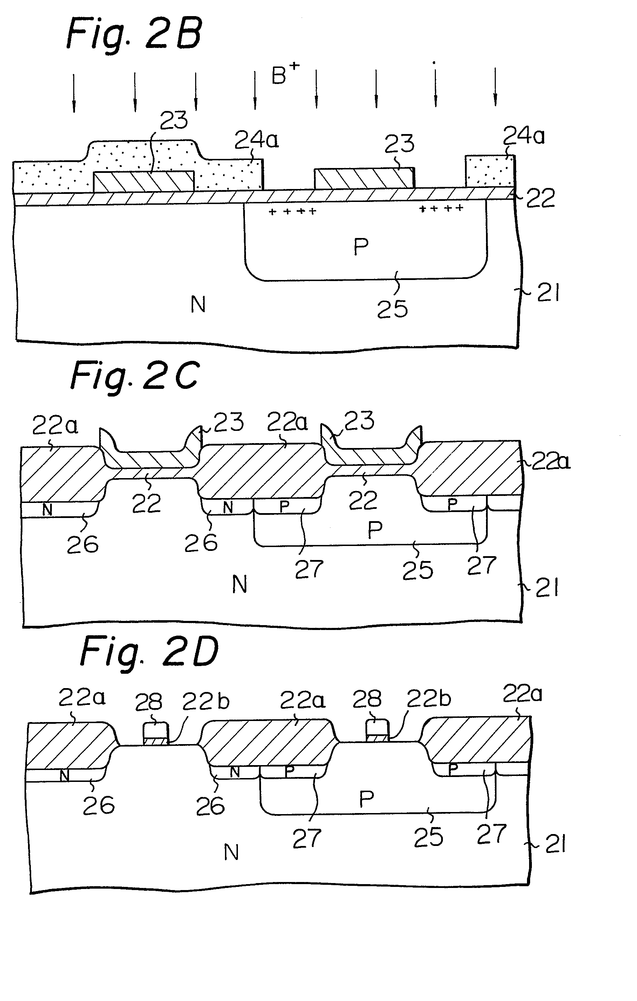

(7)  heat treatment is carried out at a temperature of about 1200°C in a nitrogen atmosphere to form p type diffusion layer (p well) 25 (Fig. 2B);

(8)  a resist film 24a is formed and patterned;

(9)  boron ions are implanted into the p type diffusion layer 25 by an ion implantation process;

(10)  the resist film 24a is removed (Fig. 2c);

(11)  a resist film (not shown) for forming the channel cut layer 26 is patterned;

(12)  phosphorus ($p^+$) ions are implanted into silicon semiconductor substrate 21 by the ion implantation process;

(13) a resist film (not shown) is removed;

(14) a field oxidation process is carried out;

(15) silicon nitride film 23 and silicon oxide film 22 are removed by an etching process (Fig. 2D);

(16) a silicon dioxide film for a gate oxide layer is formed;

(17) polycrystalline silicon is formed on the silicon dioxide film for a gate;

(18) an n type polycrystalline silicon is formed by doping phosphorous ions into the polycrystalline silicon;

(19) a silicon dioxide film for the gate oxide layer formed by step (16) and n type polycrystalline silicon is patterned to form gate oxide layer 22b and polycrystalline silicon gate 28;

(20) the patterning for $n^+$ type source or drain diffusion of an n channel transistor is carried out;

(21) arsenic ions are implanted by the ion implantation process;

(22) the resist film used in step (20) is removed;

(23) patterning for p type source-drain diffusion of p channel transistor is carried out;

(24) boron ions are implanted by the ion implantation process;

(25) after removing the resist film, the CMOS structure illustrated in Fig. 1 is formed;

(26) the entire surface of the CMOS is oxidized;

(27) phosphosilicate glass (PSG) film is formed;

(28) patterning of contact holes is carried out;

(29) aluminum for wiring is evaporated;

(30) patterning of the evaporated aluminum is carried out;

(31) the PSG cover film is grown; and

(32) the patterning of the bonding pad is carried out to complete the CMOS.

As explained above, the conventional CMOS IC uses n type polycrystalline silicon as a polycrystalline silicon gate regardless of the type of transistor, i.e., n channel or p channel.

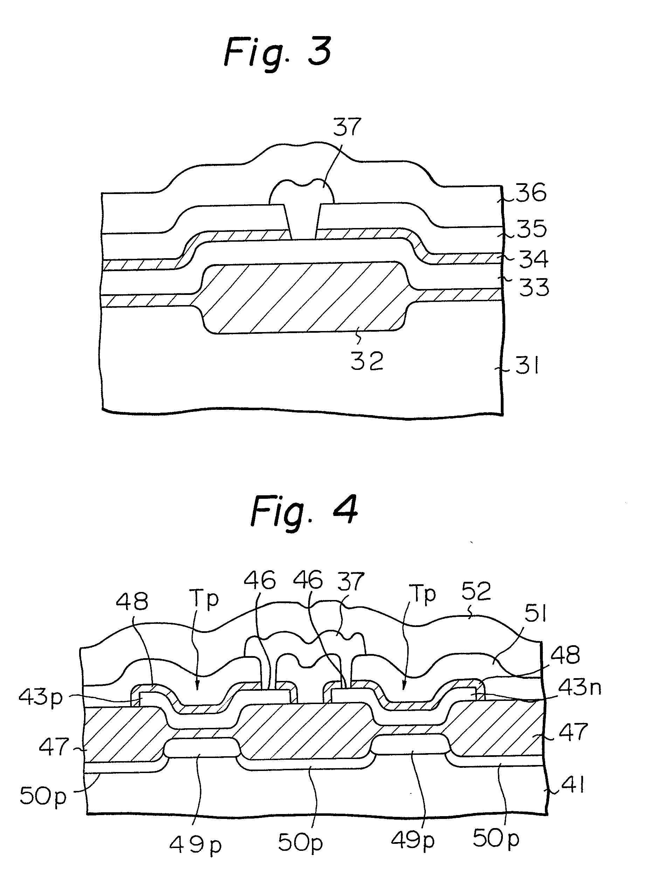

Fig. 3 is a cross-sectional view of a main portion of a CMOS illustrating a contact structure of a gate with the n type polycrystalline silicon. In Fig. 3, reference numerals 31, 32, 33, 34, 35, 36, and 37 show a semiconductor substrate (Si), field oxidation film $(SiO_2)$, n type polycrystalline silicon, silicon dioxide film, phosphosilicate glass (PSG) film, phosphosilicate glass (PSG) film and aluminum electrode, respectively.

As mentioned earlier, while a structure wherein only n type polycrystalline silicon is used as a polycrystalline silicon gate has less contact holes and easy wiring designability. The concentration of the impurities on a substrate surface of a p channel MOS transistor cannot be satisfactorily increased.

As also mentioned earlier, in another conventional CMOS structure wherein n type and p type polycrystalline silicon gate electrodes are used in n channel and p channel MOS transistors, respectively, wiring for connecting the n type polycrystalline silicon gate to the p type polycrystalline silicon gate must be carried out by using, for example, aluminum.

In the case of MOS IC's which have different type polycrystalline silicon gates, wiring for connecting the n type polycrystalline silicon gate to the p type polycrystalline silicon gate must be carried out by using, for example, aluminum.

Figure 4 illustrates such a p channel MOS IC. Referring to Fig. 4, p type polycrystalline silicon 43p and n type polycrystalline silicon 43n are formed on the field oxidation film 47, for example, silicon dioxide film. The p type polycrystalline silicon 43p is electrically connected to the n type polycrystalline silicon 43n through two contact holes 46 formed in an oxidation film 48 and PSG film 51.  In Fig. 4, reference numerals 41, 49p, 50p, and 52 illustrate an n type semiconductor substrate, p channel source or drain diffusion layer, p channel channel cut layer, and PSG layer, respectively.

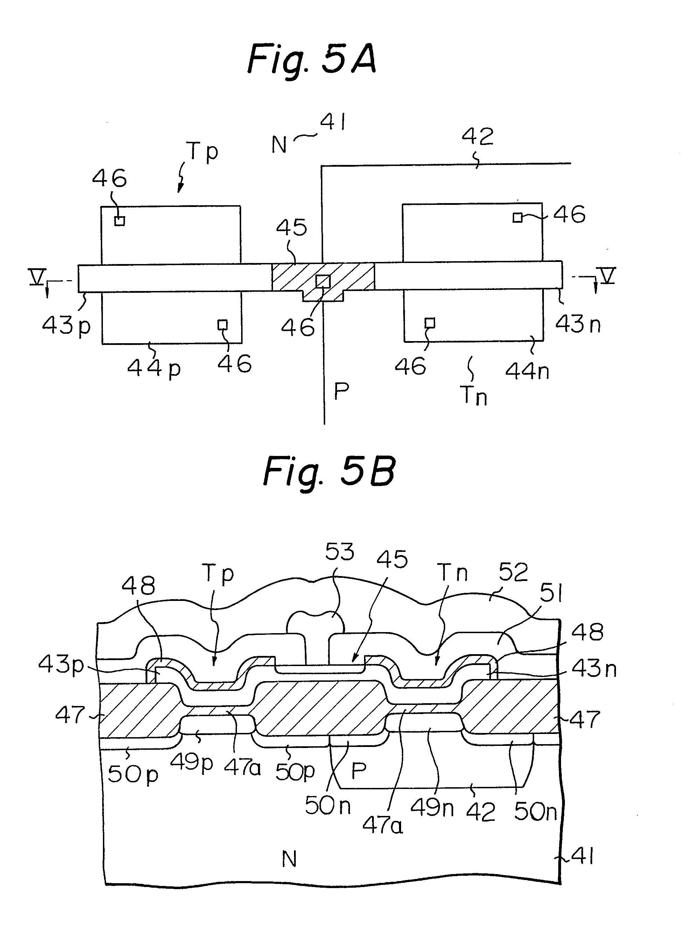

Turning now to the present invention, as shown in Fig. 5A, n type polycrystalline silicon 43n is used in an n channel MOS transistor Tn.  On the other hand, p type polycrystalline silicon 43p is used in a p channel MOS transistor Tp, the n type polycrystalline silicon 43n being ohmically connected to the p type polycrystalline silicon 43p by silicidization of polycrystalline silicon positioned between the p type and n type thereof.  In Fig. 5A, reference numerals 41, 42, 45, and 46 illustrate an n type semiconductor substrate, a p well region, a silicidized region, and a contact hole.

Referring Fig. 5B, a process for producing a semiconductor device according to the present invention will now be explained.

By carrying out the same steps (1) to (17) as in the prior art, a field oxidation film 47, channel cut diffusion layers 50n, 50p, and a p well 42 are formed. Then, gate oxidation is carried out and a polycrystalline silicon layer (not shown) is formed.  Subsequent to this, the following steps are performed:

(18')  patterning of the polycrystalline silicon is carried out;

(19')  patterning of the prior art step (20) is carried out;

(20')  the prior art step (21) is carried out to form $n^+$ type source or drain diffusion layer 49n and n type polycrystalline silicon region 43n;

(21')  the resist film used in the above patterning process is removed;

(22')  the prior art step (23) is carried out;

(23')  the prior art step (24) is carried out to form a p type polycrystalline silicon 43p and p type source and drain diffusion layer 9p;

(24') removal of the resist film corresponding to the prior art step (25) is carried out;

(25') prior art step (26) is carried out; polycrystalline silicon 43n and 43p are oxidized to form a silicon dioxide ($SiO_2$) film 48 having a thickness of 500 $\overset{\circ}{A}$ to 1500 $\overset{\circ}{A}$;

(26') portion 45, which is an inactive region of the $SiO_2$ film 48 is removed;

(27') platinum (Pt) is formed on the silicon dioxide film 48 and polycrystalline silicon of portion 45;

(28') the obtained structure is heat treated at a temperature of 250°C to 600°C in a nitrogen atmosphere to form a platinum silicide in the portion 45;

(29') the platinum on the silicon dioxide is removed by etching using aqua regia.

The CMOS IC is then completed by the prior art steps (27) to (32). In Fig. 5B, reference numerals 51 and 52 illustrate PSG film and 53 represents an aluminum electrode. Further, Tn and Tp respectively illustrate an n channel MOS transistor and p channel transistor.

When, as mentioned above, p type polycrystalline silicon is used in the p channel MOS transistor, the impurity concentration in the surface of the n type silicon substrate can be increased more than when n type polycrystalline silicon is used to the same threshold voltage. For example, with a p type polycrystalline silicon, about one order larger of impurity concentration is possible than with an n type polycrystalline silicon. In case of n type polycrystalline silicon, the surface concentration is less than $2 \times 10^{15}$ cm$^{-2}$.

This increased impurity concentration effectively resolves the problem of reduced punch through withstand voltage between the source and drain which arises in miniaturization of the gate length. According to the present invention, in a p channel MOS transistor having a gate length of 2 to 2.5 μm, the punch through withstand voltage is about 10 V at the Vth of -1.0 V in the n type polycrystalline silicon gate. On the other hand, in the p type polycrystalline silicon gate, the gate length can be obtained 1.0 μm at the same punch through withstand voltage and at the same Vth. Namely, there is more than 1.0 μm improvement in the gate length of the p type polycrystalline silicon gate compared to in the n type polycrystalline silicon gate.

It is also important in view of low power consumption and low voltage operation that the threshold voltage Vth be maintained at a lower level upon the increase of the surface impurity concentration. This can be easily accomplished by the present invention.

The threshold voltage Vth of a MOS transistor is approximately expressed by the following expression

$$Vth = (1/Co) \cdot (2 \varepsilon Si \varepsilon_0 qNd |2\phi_f|)^{1/2} + 2\phi_f + \phi_{ms} + Q_{ss}/Co$$

wherein: $\phi_f$ is an energy width between an fermi level and an intrinsic level, $Q_{ss}$ is a surface charge density. $\phi_{ms}$ is a difference in work function between the gate electrode and a substrate, Co is a capacitance between the gate electrode and the silicon substrate, and Nd, q, $\varepsilon_0$, and εSi are the impurity concentration, electric charge of electrons, vacuum dielectric constant, and specific dielectric constant of the silicon substrate.

According to the above expression, the effect on the Vth due to the increase of the surface impurity concentration Nd is decreased by changing $\phi_{ms}$ by selection of the gate material or by increasing the gate capacitance.

The values of $\phi_{ms}$ are different according to the kinds of gate metal. When p type polycrystalline silicon is used, as in the present invention, the absolute value of Vth of a p channel MOS transistor becomes less than when n type polycrystalline silicon is conventionally used.

Therefore, it is valuable to use p type polycrystalline silicon in a p channel MOS transistor so as to obtain a high punch through withstand voltage and low threshold voltage. The capacitance of the gate oxidation film Co is increased by using thinner the gate oxidation film.

Electric contact between electrodes is effected through, for example, platinum silicide 45, as shown in Fig. 5B, without aluminum wiring between the p type polycrystalline silicon and n type polycrystalline silicon. Therefore, the number of contact holes can be decreased.

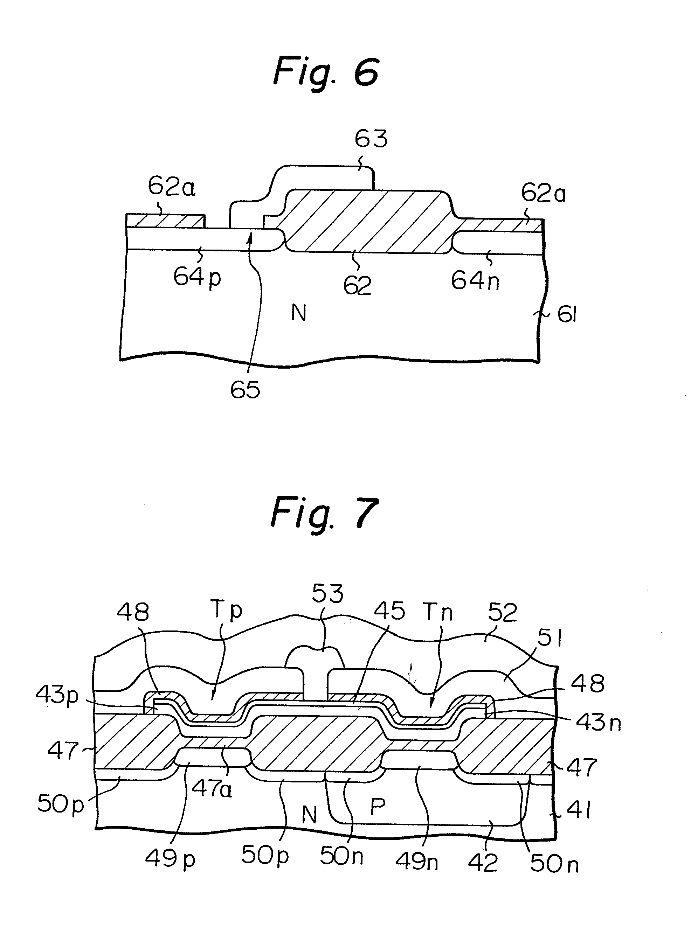

Furthermore, according to the present invention, buried contact 65, which directly connects the polycrystalline silicon 63 to the p type diffusion layer 64p, is easily carried out as shown in Fig. 6. In the conventional method, only n type polycrystalline silicon was used. Thus, since a P - N junction is formed between a p type diffusion layer and a polycrystalline silicon, the buried contact was used only between n type diffusion layer and the polycrystalline silicon.

However, in the present invention, such a problem does not occur. In Fig. 6, reference numerals 62, 62a, 63, and 64p show a field oxidation film, a gate oxidation film, p type polycrystalline silicon gate, and a p channel source or drain diffusion layer. The channel cut diffusion layer, n type polycrystalline silicon gate, p well, etc. are omitted from the illustration.

The silicide layer 45 can be made on the polycrystalline silicon over the active region as shown in Fig. 7 which is approximately similar to Fig. 5B.

In this case, it is preferable to use molybdenum silicide tungsten silicide.  Barrier material preventing
diffusion of silicon atoms and metal atoms of silicide
may be used between the polycrystalline silicon and the
silicide layer.

## CLAIMS

1. A semiconductor device comprising: a first transistor having a first gate, said first gate being made of a polycrystalline silicon of a first conductivity type; a second transistor having a second gate, said second gate being made of a polycrystalline silicon of a second conductivity type which is opposite to said first conductivity type: characterized in that said first and second gates are ohmically connected with a silicide layer to each other.

2. A semiconductor device according to claim 1, characterized in that said first transistor and said second transistor forms a CMOS transistor.

3. A semiconductor device according to claim 1, characterized in that said first transistor is a p channel MOS transistor and said second transistor is a n channel MOS transistor.

4. A semiconductor device according to claim 1 characterized in that said first conductivity type is the p type and said second conductivity type is the n type.

5. A semiconductor device according to claim 1, characterized in that said silicide is selected from the group consisting of platinum silicide, molybdenum silicide, and tungsten silicide.

## Fig. 1

## Fig. 2A

## Fig. 2B

B⁺

23    24a    23    24a

22

+ + + +        + + + +

P

N        25        21

## Fig. 2C

22a        23    22a        23        22a

N    22        N    P    22    P

26        26        27    25    27    21

N

## Fig. 2D

22a    28    22b    22a    28    22b    22a

N        N    P        P

26        26        27    25    27    21

P

N

## Fig. 3

37

36
35
34
33

32

31

## Fig. 4

48  Tp  46  46  37  Tp  52  51

48

43p

43n

47

47

50p

41

49p  50p  49p  50p

## Fig. 5A

## Fig. 5B

## Fig. 6

62a  63  62a
64p  62  64n
N  61
65

## Fig. 7

48  Tp  53  45  Tn  52
43p  51
48
47  43n
50p  47
47a  41
50p
49p  50p  50n  49n  42  50n
N  P